# EUROPEAN PATENT APPLICATION

(11) **EP 4 679 717 A2**
(43) Date of publication of application: **14.01.2026**
(21) Application number: 25217867.8
(22) Date of filing: 24.11.2025
(51) Int. Cl.: H03M 7/30

(54) **SYSTEM AND METHOD FOR IMPLEMENTING DATA COMPRESSION, STORAGE MEDIUM, AND ELECTRONIC DEVICE**

(30) Priority: 17.06.2025 CN 202510813116
(71) Applicant: Beijing Horizon Robotics Technology Research and Development Co., Ltd., Beijing 100094 (CN)
(72) Inventor: QU, Xinyuan, Beijing, 100094 (CN)
(74) Representative: Dehns Germany Partnerschaft mbB

(57) **Abstract**

Disclosed are a system for implementing data compression and method, a storage medium, and an electronic device. The system includes: a data obtaining circuit configured to obtain to-be-compressed data; a control circuit and a plurality of data compression circuits, where the control circuit is configured to control the plurality of data compression circuits to compress sample data to generate first compressed data respectively corresponding to the plurality of data compression circuits; determine a target data compression circuit adaptable to the sample data from the plurality of data compression circuits based on the first compressed data respectively corresponding to the plurality of data compression circuits; and control the target data compression circuit to compress data other than the sample data, to generate second compressed data; and a data output circuit configured to output the first compressed data corresponding to the target data compression circuit and the second compressed data.

## Description

### TECHNICAL FIELD

This disclosure relates to data compression technologies, and in particular, to a system and method for implementing data compression, a storage medium, and an electronic device.

### BACKGROUND

A data compression scheme is a common data processing operation in a chip. Through the data compression scheme, less storage resources and bandwidth resources may be used to implement data storage and transmission, thereby reducing an on-chip area and power consumption of the chip.

In a conventional data compression scheme, a data compression algorithm is usually preset and to-be-compressed data is uniformly compressed according to the preset data compression algorithm, making it difficult to achieve an optimal data compression effect. How to improve the data compression effect is a technical problem worthy of attention for a person skilled in the art.

### SUMMARY

To resolve the foregoing technical problem, this disclosure provides a system for implementing data compression and method, a storage medium, and an electronic device.

According to an aspect of an embodiment of this disclosure, a system for implementing data compression is provided, including:
a data obtaining circuit, wherein the data obtaining circuit is configured to obtain to-be-compressed data;
a control circuit and a plurality of data compression circuits, wherein the control circuit is configured to control the plurality of data compression circuits to compress sample data in the to-be-compressed data respectively, to generate first compressed data respectively corresponding to the plurality of data compression circuits; determine a target data compression circuit adaptable to the sample data from the plurality of data compression circuits based on the first compressed data respectively corresponding to the plurality of data compression circuits; and control the target data compression circuit to compress data other than the sample data in the to-be-compressed data, to generate second compressed data; and
a data output circuit, where the data output circuit is configured to output the second compressed data and the first compressed data corresponding to the target data compression circuit.

According to another aspect of an embodiment of this disclosure, a data compression method is provided, including:
obtaining to-be-compressed data;
controlling a plurality of data compression circuits to compress sample data in the to-be-compressed data respectively, to generate first compressed data respectively corresponding to the plurality of data compression circuits;
determining a target data compression circuit adaptable to the sample data from the plurality of data compression circuits based on the first compressed data respectively corresponding to the plurality of data compression circuits;
controlling the target data compression circuit to compress data other than the sample data in the to-be-compressed data, to generate second compressed data; and
outputting the first compressed data corresponding to the target data compression circuit and the second compressed data.

According to still another aspect of an embodiment of this disclosure, a computer readable storage medium is provided. The storage medium stores a computer program, and the computer program is executed by a processor to implement the data compression method described above.

According to yet another aspect of an embodiment of this disclosure, an electronic device is provided, where the electronic device includes:
a processor; and
a memory, configured to store processor-executable instructions, where
the processor is configured to read the executable instructions from the memory, and execute the instructions to implement the data compression method described above.

According to still yet another aspect of an embodiment of this disclosure, a computer program product is provided. When instructions in the computer program product are executed by a processor, the data compression method described above is implemented.

According to the system for implementing data compression and method, the storage medium, the electronic device, and the program product that are provided in the foregoing embodiments of this disclosure, the to-be-compressed data may be compressed at two stages. During compression at a first stage, under the control of the control circuit, the plurality of data compression circuits may be used to compress the sample data in the to-be-compressed data respectively, to generate the first compressed data respectively corresponding to the plurality of data compression circuits. On this basis, data compression effects of the plurality of data compression circuits for the sample data are evaluated, so as to determine the target data compression circuit adaptable to the sample data. During compression at a second stage, under the control of the control circuit, the target data compression circuit may be used to compress the data other than the sample data in the to-be-compressed data, to generate the second compressed data. The data output circuit may output the second compressed data and the first compressed data corresponding to the target data compression circuit. Since both the first compressed data corresponding to the target data compression circuit and the second compressed data are generated by the target data compression circuit, it is equivalent to that a data compression result of the to-be-compressed data is generated by using the target data compression circuit, and the data compression result generated by the target data compression circuit is output through the data output circuit. In view of the above, by adopting a hardware compression architecture in the embodiments of this disclosure, the data compression circuit used to compress the to-be-compressed data can be adaptively determined, which is equivalent to adaptively determining a compression algorithm for the to-be-compressed data. Compressing the to-be-compressed data by using the determined compression algorithm helps improve the data compression effect.

### BRIEF DESCRIPTION OF THE DRAWINGS

FIG. 1 is a schematic diagram 1 of a structure of a system for implementing data compression according to some exemplary embodiments of this disclosure;
FIG. 2 is a schematic diagram 2 of a structure of a system for implementing data compression according to some exemplary embodiments of this disclosure;
FIG. 3 is a schematic diagram 3 of a structure of a system for implementing data compression according to some exemplary embodiments of this disclosure;
FIG. 4 is a schematic diagram 4 of a structure of a system for implementing data compression according to some exemplary embodiments of this disclosure;
FIG. 5 is a schematic diagram 5 of a structure of a system for implementing data compression according to some exemplary embodiments of this disclosure;
FIG. 6 is a schematic flowchart 1 of a data compression method according to some exemplary embodiments of this disclosure;
FIG. 7 is a schematic flowchart 2 of a data compression method according to some exemplary embodiments of this disclosure;
FIG. 8 is a schematic flowchart 3 of a data compression method according to some exemplary embodiments of this disclosure;
FIG. 9 is a schematic flowchart 4 of a data compression method according to some exemplary embodiments of this disclosure;
FIG. 10 is a schematic flowchart 5 of a data compression method according to some exemplary embodiments of this disclosure;
FIG. 11 is a schematic flowchart 6 of a data compression method according to some exemplary embodiments of this disclosure;
FIG. 12 is a schematic flowchart 7 of a data compression method according to some exemplary embodiments of this disclosure; and
FIG. 13 is a schematic diagram of a structure of an electronic device according to some exemplary embodiments of this disclosure.

### DETAILED DESCRIPTION OF THE EMBODIMENTS

To explain this disclosure, exemplary embodiments of this disclosure are described below in detail with reference to accompanying drawings. Obviously, the embodiments described are merely some, rather than all of embodiments of this disclosure. It should be understood that this disclosure is not limited to the exemplary embodiments.

It should be noted that unless otherwise specified, the scope of this disclosure is not limited by relative arrangement, numeric expressions, and numerical values of components and steps described in these embodiments.

### Application overview

Currently, application of chips becomes increasingly widespread. For example, in the field of driving technologies, application of intelligent driving chips and intelligent cockpit chips becomes increasingly widespread.

A data compression scheme is a common data processing operation in chips. In a conventional data compression scheme, a data compression algorithm is usually preset and to-be-compressed data is uniformly compressed according to the preset data compression algorithm, making it difficult to achieve an optimal data compression effect, which easily leads to wastes of storage resources and bandwidth resources. Therefore, it is needed to take some measures to improve the data compression effect.

### Exemplary system

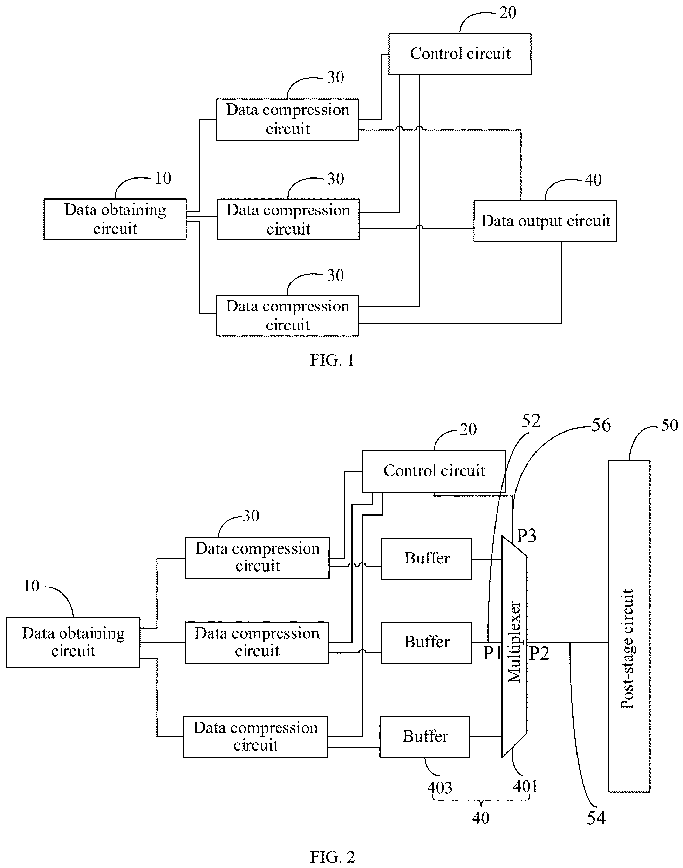

FIG. 1 is a schematic diagram of a structure of a system for implementing data compression according to some exemplary embodiments of this disclosure. As shown in FIG. 1, the system for implementing data compression may include:
a data obtaining circuit 10, wherein the data obtaining circuit 10 is configured to obtain to-be-compressed data;
a control circuit 20 and a plurality of data compression circuits 30, wherein the control circuit 20 is configured to control the plurality of data compression circuits 30 to compress sample data in the to-be-compressed data respectively, to generate first compressed data respectively corresponding to the plurality of data compression circuits 30; determine a target data compression circuit adaptable to the sample data from the plurality of data compression circuits 30 based on the first compressed data respectively corresponding to the plurality of data compression circuits 30; and control the target data compression circuit to compress data other than the sample data in the to-be-compressed data, to generate second compressed data; and
a data output circuit 40, wherein the data output circuit 40 is configured to output the second compressed data and the first compressed data corresponding to the target data compression circuit.

For ease of description, the system for implementing data compression may be referred to as a target system below.

Optionally, the data obtaining circuit 10 may be a circuit with a data obtaining function in the target system. The data obtaining circuit 10 may obtain data that needs to be compressed, which may be referred to as to-be-compressed data. The to-be-compressed data may include, but is not limited to image data, feature map data, and point cloud data. For example, the target system may be designed in an intelligent driving chip, and a vehicle equipped with the intelligent driving chip may be provided with a camera and a radar. The image data included in the to-be-compressed data may be environmental image data collected by the camera. The feature map data included in the to-be-compressed data may be feature map data obtained by performing a predetermined operation on the environmental image data collected by the camera. The point cloud data included in the to-be-compressed data may be environmental point cloud data collected by the radar. Herein, the predetermined operation may include but is not limited to a tensor operation and a vector operation. The tensor operation may include a convolution operation, such as a two-dimensional convolution operation or a three-dimensional convolution operation. The vector operation may include a point-to-point element-wise operation, such as a point-to-point element-wise multiplication operation or a point-to-point element-wise addition operation.

Optionally, the control circuit 20 may be a circuit with a control function in the target system. The control circuit 20 may be configured to control circuits other than the control circuit 20 in the target system, to assist in achieving a good data compression effect.

Optionally, the plurality of data compression circuits 30 may all be circuits with a data compression function in the target system, and may correspond to different compression algorithms. The compression algorithm corresponding to any data compression circuit 30 refers to a compression algorithm used by that data compression circuit 30 to perform a data compression operation. The plurality of data compression circuits 30 may be electrically connected to the data obtaining circuit 10 respectively, and may also be electrically connected to the control circuit 20 respectively. For example, the plurality of data compression circuits 30 may be three data compression circuits 30. A compression algorithm corresponding to a first data compression circuit 30 may be a run-length compression algorithm, and the first data compression circuit 30 may also be referred to as an RLE module. A compression algorithm corresponding to a second data compression circuit 30 may be a bitmap compression algorithm, and the second data compression circuit 30 may also be referred to as a BITMAP module. A compression algorithm corresponding to a third data compression circuit 30 may be a sparse matrix (compressed sparse row, CSR) compression algorithm, and the third data compression circuit 30 may also be referred to as a CSR module.

Optionally, the data output circuit 40 may be a circuit with a data output function in the target system, and may be electrically connected to the plurality of data compression circuits 30, respectively. For example, the data obtaining circuit 10, the control circuit 20, and the plurality of data compression circuits 30 may work together to generate a data compression result for the to-be-compressed data. The data output circuit 40 may output the data compression result of the to-be-compressed data to a specific circuit (such as a post-stage circuit 50 below) in the target system, or output the data compression result of the to-be-compressed data to outside of the target system.

In the embodiments of this disclosure, the control circuit 20 may control the plurality of data compression circuits 30 to respectively compress, according to the corresponding compression algorithms, the sample data in the to-be-compressed data obtained by the data obtaining circuit 10, so as to generate the first compressed data respectively corresponding to the plurality of data compression circuits 30. The sample data may be data for assisting in determining a compression algorithm suitable for the to-be compressed data. The data other than the sample data in the to-be compressed data may also be referred to as non-sample data below. For example, the sample data may be data of a predetermined proportion in the to-be-compressed data. The predetermined proportion may be, for example, 10%, 15%, or 20%, which are not enumerated herein.

The control circuit 20 may also evaluate data compression effects of the plurality of data compression circuits 30 for the sample data based on the first compressed data respectively corresponding to the plurality of data compression circuits 30. On this basis, the data compression circuit 30 that can achieve an excellent data compression effect for the sample data can be determined from the plurality of data compression circuits 30. The determined data compression circuit 30 may be used as the target data compression circuit adaptable to the sample data.

Since both the sample data and the non-sample data are located in the to-be-compressed data, data characteristics of the sample data and the non-sample data are usually similar. For example, information entropies of the sample data and the non-sample data are relatively close. The inventor finds through research that under a premise of similar data characteristics between the sample data and the non-sample data, the target data compression circuit adaptable to the sample data can usually also be adaptable to the non-sample data. In view of the above, the control circuit 20 may control the target data compression circuit to compress the non-sample data according to a corresponding compression algorithm, to generate the second compressed data. In this way, an excellent data compression effect may also be achieved for the non-sample data.

The control circuit 20 may also control the data output circuit 40 to output the first compressed data corresponding to the target data compression circuit and the second compressed data. Since the first compressed data corresponding to the target data compression circuit is compressed data obtained by compressing the sample data, the second compressed data is compressed data obtained by compressing the non-sample data, and the to-be-compressed data only includes the sample data and the non-sample data, that the data output circuit 40 outputs the first compressed data corresponding to the target data compression circuit and the second compressed data is equivalent to entirely outputting the data compression result of the to-be-compressed data (including the first compressed data corresponding to the target data compression circuit and the second compressed data).

In the embodiments of this disclosure, the to-be-compressed data may be compressed at two stages. During compression at a first stage, under the control of the control circuit 20, the plurality of data compression circuits 30 may be used to compress the sample data in the to-be-compressed data respectively, to generate the first compressed data respectively corresponding to the plurality of data compression circuits 30. On this basis, data compression effects of the plurality of data compression circuits 30 for the sample data are evaluated, so as to determine the target data compression circuit adaptable to the sample data. During compression at a second stage, under the control of the control circuit 20, the target data compression circuit may be used to compress the data other than the sample data in the to-be-compressed data, to generate the second compressed data. The data output circuit 40 may output the second compressed data and the first compressed data corresponding to the target data compression circuit. Since both the first compressed data corresponding to the target data compression circuit and the second compressed data are generated by the target data compression circuit, it is equivalent to that the data compression result of the to-be-compressed data is generated by using the target data compression circuit, and the data compression result generated by the target data compression circuit is output through the data output circuit 40. In view of the above, by adopting a hardware compression architecture in the embodiments of this disclosure, the data compression circuit 30 used to compress the to-be-compressed data can be adaptively determined, which is equivalent to adaptively determining a compression algorithm for the to-be-compressed data. Compressing the to-be-compressed data by using the determined compression algorithm helps improve the data compression effect.

In some optional examples, the target system may include:
a lossy data compression circuit set and a lossless data compression circuit set.

That the control circuit 20 is configured to control the plurality of data compression circuits 30 to compress sample data in the to-be-compressed data respectively may include:
the control circuit 20 is configured to determine a compression mode of the to-be-compressed data; in response to that the compression mode of the to-be-compressed data is a lossy compression mode, control a plurality of data compression circuits 30 in the lossy data compression circuit set to compress the sample data respectively; and in response to that the compression mode of the to-be-compressed data is a lossless compression mode, control a plurality of data compression circuits 30 in the lossless data compression circuit set to compress the sample data respectively.

Optionally, the lossy data compression circuit set may include a plurality of data compression circuits 30, for example, may include N1 data compression circuits 30, wherein each data compression circuit 30 may be a lossy data compression circuit. The lossless data compression circuit set may also include a plurality of data compression circuits 30, for example, may include N2 data compression circuits 30, wherein each data compression circuit 30 may be a lossless data compression circuit. N2 and N1 are both integers greater than or equal to 2, and N2 and N1 may be equal or unequal. It may be understood that the lossless data compression circuit is a hardware circuit that implements data compression while ensuring information integrity; and the lossy data compression circuit is a hardware circuit that implements more efficient data compression by discarding a part of non-critical information.

In the embodiments of this disclosure, the control circuit 20 may determine the compression mode of the to-be-compressed data. The compression mode of the to-be-compressed data may have two cases: a lossy compression mode and a lossless compression mode. The lossy compression mode may be understood as a compression mode for implementing more efficient data compression by discarding a part of non-critical information, while the lossless compression mode may be understood as a compression mode for implementing data compression while ensuring information integrity.

It should be noted that there are various manners for determining the compression mode of the to-be-compressed data. For example, if the to-be-compressed data is used for environmental perception in an autonomous driving scenario, due to high sensitivity of environmental perception to information loss in the autonomous driving scenario, driving safety may be affected when the information loss accumulates to a certain extent. Therefore, the compression mode of the to-be-compressed data may be a lossless compression mode without information loss. If the to-be-compressed data is used for a vehicle-mounted entertainment activity (such as listening to music) in a parking scenario, due to low sensitivity of the vehicle-mounted entertainment activity to information loss, the compression mode of the to-be-compressed data may be a lossy compression mode that facilitates more efficient data compression.

If the compression mode of the to-be compressed data is the lossy compression mode, the control circuit 20 may control the N1 data compression circuits 30 in the lossy data compression circuit set to compress the sample data respectively. Referring to the first compressed data corresponding to the N1 data compression circuits 30, one data compression circuit 30 may be selected from the N1 data compression circuits 30 to serve as the target data compression circuit adaptable to the sample data.

If the compression mode of the to-be compressed data is the lossless compression mode, the control circuit 20 may control the N2 data compression circuits 30 in the lossless data compression circuit set to compress the sample data respectively. Referring to the first compressed data corresponding to the N2 data compression circuits 30, one data compression circuit 30 may be selected from the N2 data compression circuits 30 to serve as the target data compression circuit adaptable to the sample data.

In this way, since the target system includes the lossy data compression circuit set and the lossless data compression circuit set, the target data compression circuit may be adaptively selected from the corresponding data compression circuit set based on the compression mode of the to-be-compressed data, so as to compress the to-be-compressed data by using the target data compression circuit. Therefore, the hardware compression architecture in the embodiments of this disclosure has high flexibility and can be applied to various scenarios.

In some optional examples, that the control circuit 20 is configured to control a plurality of data compression circuits 30 in the lossy data compression circuit set to compress the sample data may include:
the control circuit 20 is configured to determine a shared information loss rate of the plurality of data compression circuits 30 in the lossy data compression circuit set; and control the plurality of data compression circuits 30 in the lossy data compression circuit set to compress the sample data respectively according to the shared information loss rate.

In the embodiments of this disclosure, if the compression mode of the to-be compressed data is the lossy compression mode, the control circuit 20 may determine the shared information loss rate of the N1 data compression circuits 30 in the lossy data compression circuit set. The shared information loss rate refers to an information loss rate uniformly used by the N1 data compression circuits 30 when performing data compression operations (that is, a loss rate of data information during a data compression process). The shared information loss rate may be an information loss rate pre-configured in the control circuit 20; or may be an information loss rate sent to the control circuit 20 by a host computer. The host computer may be, for example, a central processing unit (CPU) outside the target system. The shared information loss rate may be, for example, 10%, 15%, or 20%, which are not enumerated herein. The control circuit 20 may notify the N1 data compression circuits 30 of the shared information loss rate, and control the N1 data compression circuits 30 to compress the sample data in the to-be compressed data respectively according to the shared information loss rate. In this way, during the process in which the N1 data compression circuits 30 compress the sample data respectively, information loss rates of the N1 data compression circuits 30 can remain consistent. In this case, when the target data compression circuit adaptable to the sample data is determined from the N1 data compression circuits 30 based on the first compressed data corresponding to the N1 data compression circuits 30, adverse effects that may be brought in by inconsistent information loss rates can be effectively avoided, thereby improving accuracy and reliability of a determining result.

In some embodiments, if the compression mode of the to-be compressed data is the lossless compression mode, the control circuit 20 does not need to determine the shared information loss rate, but directly control the N2 data compression circuits 30 in the lossless data compression circuit set to compress the sample data, respectively.

In some embodiments, that the control circuit 20 is configured to determine a target data compression circuit adaptable to the sample data from the plurality of data compression circuits 30 based on the first compressed data respectively corresponding to the plurality of data compression circuits 30 may include:
the control circuit 20 is configured to determine respective compression ratios of the plurality of data compression circuits 30 for the sample data based on the first compressed data respectively corresponding to the plurality of data compression circuits 30; determine a magnitude relationship between the compression ratios corresponding to the plurality of data compression circuits 30; and determine the target data compression circuit adaptable to the sample data from the plurality of data compression circuits 30 based on the magnitude relationship.

Optionally, the control circuit 20 may determine a first data amount of the sample data, and may also determine second data amounts of the first compressed data respectively corresponding to the plurality of data compression circuits 30. The control circuit 20 may calculate ratios between the second data amounts of the first compressed data respectively corresponding to the plurality of data compression circuits 30 and the first data amount, and determine the ratio corresponding to any data compression circuit 30 as the compression rate of that data compression circuit 30 for the sample data. In this way, the control circuit 20 may determine a plurality of compression ratios in one-to-one correspondence to the plurality of data compression circuits 30. The control circuit 20 may compare values of the plurality of compression ratios in pairs to determine a magnitude relationship between any two of the plurality of compression ratios. The control circuit 20 may also determine the target data compression circuit adaptable to the sample data from the plurality of data compression circuits 30 based on the magnitude relationship between any two of the plurality of compression ratios. For example, the control circuit 20 may select a target compression ratio with a smallest value from the plurality of compression ratios based on the magnitude relationship between any two of the plurality of compression ratios, and determine the data compression circuit 30 corresponding to the target compression ratio as the target data compression circuit adaptable to the sample data.

In some embodiments, there may be a case where two compression ratios share a smallest value among the plurality of compression ratios. In this case, the control circuit 20 may randomly select one data compression circuit 30 from two data compression circuits 30 corresponding to the two compression ratios sharing a smallest value to serve as the target data compression circuit adaptable to the sample data.

Certainly, the way in which the control circuit 20 determines the target data compression circuit is not limited thereto. For example, in some cases, the data compression circuit 30 corresponding to a compression ratio with a second smallest value among the plurality of compression ratios may also be determined as the target data compression circuit. For example, a smallest compression ratio among the plurality of compression ratios is referred to as a first compression ratio, and a second smallest compression ratio is referred to as a second compression ratio. If a difference between the first compression ratio and the second compression ratio is small (for example, in within 5%), and a compression speed of the data compression circuit 30 corresponding to the second compression ratio is significantly superior to that of the data compression circuit 30 corresponding to the first compression ratio (for example, the compression speed of the data compression circuit 30 corresponding to the second compression ratio is faster by more than 30%), in a case of high requirements for the compression speed, the data compression circuit 30 corresponding to the second compression ratio may be determined as the target data compression circuit.

In the embodiments of this disclosure, the control circuit 20 may determine the respective compression ratios of the plurality of data compression circuits 30 for the sample data. It should be noted that a smaller compression ratio value corresponding to the data compression circuit 30 indicates a higher space saving rate when the sample data is compressed by using this data compression circuit 30. Correspondingly, a data compression effect of this data compression circuit 30 for the sample data is better. A larger compression ratio value corresponding to the data compression circuit 30 indicates a lower space saving rate when the sample data is compressed by using this data compression circuit 30. Correspondingly, a data compression effect of this data compression circuit 30 for the sample data is worse. In view of the above, the control circuit 20 can effectively evaluate the data compression effects of the plurality of data compression circuits 30 for the sample data based on the compression ratios corresponding to the plurality of data compression circuits 30. By determining the magnitude relationship between the compression ratios corresponding to the plurality of data compression circuits 30, the control circuit 20 can effectively determine relative advantages and disadvantages of the data compression effects of the plurality of data compression circuits 30 for the sample data. On this basis, the control circuit 20 can select the data compression circuit 30 that can achieve an optimal data compression effect for the sample data from the plurality of data compression circuits 30, and determine that data compression circuit 30 as the target data compression circuit. Generating the data compression result of the to-be-compressed data by using the target data compression circuit can achieve an excellent data compression effect.

In some optional examples, as shown in FIG. 2, the data output circuit 40 may include a multiplexer 401 and buffers 403 corresponding to the plurality of data compression circuits 30. The target system may further include a post-stage circuit 50.

That the data output circuit 40 is configured to output the first compressed data corresponding to the target data compression circuit and the second compressed data may include:
the buffers 403 corresponding to the plurality of data compression circuits 30 are configured to buffer compressed data generated by the corresponding data compression circuits 30; and
the control circuit 20 is configured to control the multiplexer 401 to conduct a first bus between the buffer 403 corresponding to the target data compression circuit and the post-stage circuit 50, so that the first compressed data buffered in the buffer 403 corresponding to the target data compression circuit and the second compressed data are transmitted to the post-stage circuit 50 through the first bus.

Optionally, the multiplexer 401 may be a multiple-input-single-output selector in the data output circuit 40, and is configured to select an input signal from a plurality of input signals based on a control signal and output the selected input signal.

Optionally, the buffer 403 may be a device used in the data output circuit 40 for temporarily storing data. There may be a plurality of buffers 403 in one-to-one correspondence to the plurality of data compression circuits 30. Any buffer 403 may be electrically connected to the corresponding data compression circuit 30, to buffer the compressed data generated by that data compression circuit 30.

Optionally, the post-stage circuit 50 may be a circuit in the target system that is configured to further process the data output from the data output circuit 40. For example, if the further processing herein may be storage processing, the post-stage circuit 50 may be a memory. The post-stage circuit 50 may include, but is not limited to a double data rate (DDR) synchronous dynamic random access memory and a static random-access memory (SRAM). In some embodiments, the further processing herein may also be tensor operation processing, vector operation processing, or other processing, which are not enumerated herein.

As shown in FIG. 2, the multiplexer 401 may include a plurality of input ends P1, an output end P2, and a control end P3. The plurality of input ends P1 may be electrically connected in one-to-one correspondence to the plurality of buffers 403 through a plurality of buses 52, the output end P2 may be electrically connected to the post-stage circuit 50 through a bus 54, and the control end P3 may be electrically connected to the control circuit 20 through a bus 56. The first bus between any buffer 403 and the post-stage circuit 50 may include the bus 52 corresponding to that buffer 403 and the bus 54.

After being generated by the plurality of data compression circuits 30 by compressing the sample data respectively, the first compressed data respectively corresponding to the plurality of data compression circuits 30 may be stored in the corresponding buffers 403, respectively. After the target data compression circuit adaptable to the sample datais determined by the control circuit 20, and the second compressed data is generated by the target data compression circuit by compressing the non-sample data, the second compressed data may be stored in the buffer 403 corresponding to the target data compression circuit.

After determining the target data compression circuit, the control circuit 20 may send a first control signal to the multiplexer 401 through the bus 56, so that the multiplexer 401 responds to the first control signal and connects the input end P1 corresponding to the target data compression circuit to the output end P2. When the input end P1 corresponding to the target data compression circuit is connected to the output end P2, the first bus (including the bus 52 corresponding to the buffer 403 and the bus 54) between the buffer 403 corresponding to the target data compression circuit and the post-stage circuit 50 is conducted. Correspondingly, the first compressed data buffered in the buffer 403 corresponding to the target data compression circuit may be transmitted to the post-stage circuit 50 through the first bus. Similarly, the second compressed data buffered in the buffer 403 corresponding to the target data compression circuit may also be transmitted to the post-stage circuit 50 through the first bus.

Optionally, when the input end P1 corresponding to the target data compression circuit is connected to the output end P2, the input ends P1 other than the input end P1 corresponding to the target data compression circuit may be remained disconnected from the output end P2. In this way, the first compressed data buffered in the buffers 403 other than the buffer 403 corresponding to the target data compression circuit would not be transmitted to the post-stage circuit 50. In other words, the post-stage circuit 50 may only obtain the data compression result generated by the target data compression circuit.

In the embodiments of this disclosure, by introducing the buffers 403 and the multiplexer 401, after the target data compression circuit adaptable to the sample data is determined from the plurality of data compression circuits 30, it is only needed to control the multiplexer 401 by using the control circuit 20, so that the data compression result generated by the target data compression circuit can be transmitted to the post-stage circuit 50 through the first bus for further processing by the post-stage circuit 50.

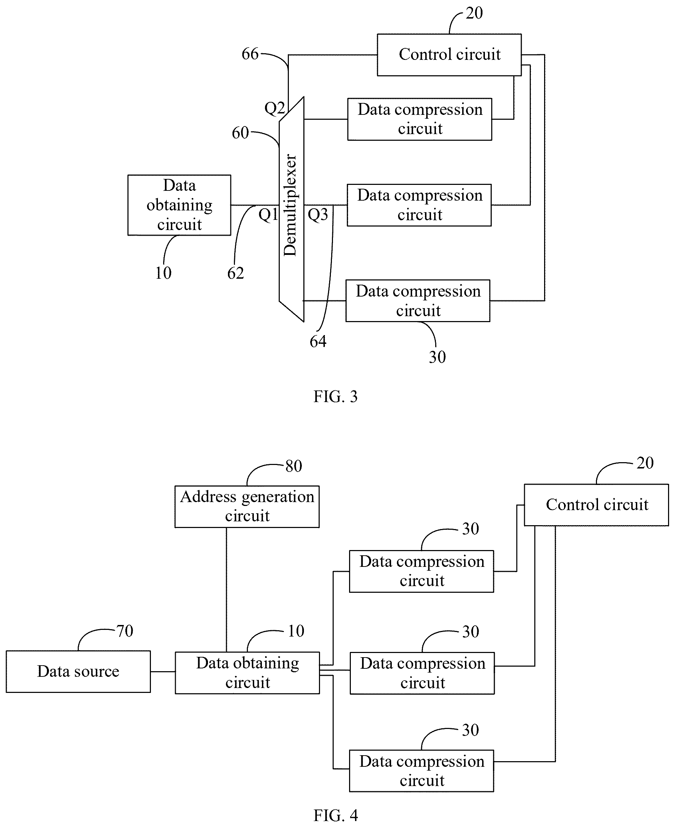

In some optional examples, as shown in FIG. 3, the target system may also include a demultiplexer 60.

Before being configured to control the plurality of data compression circuits 30 to compress the sample data in the to-be-compressed data respectively, the control circuit 20 is configured to control the demultiplexer 60 to conduct second buses between the data obtaining circuit 10 and the plurality of data compression circuits 30, so that the sample data is transmitted to the corresponding data compression circuits 30 through the second buses.

Before being configured to control the target data compression circuit to compress the data other than the sample data in the to-be-compressed data, the control circuit 20 is configured to control the demultiplexer 60 to maintain communication of the second bus between the data obtaining circuit 10 and the target data compression circuit, and control the demultiplexer 60 to block communication of the second buses between the data obtaining circuit 10 and other data compression circuits 30, so that the data other than the sample data in the to-be-compressed data is transmitted to the target data compression circuit through the second bus corresponding to the target data compression circuit. The other data compression circuits refer to the data compression circuits 30 other than the target data compression circuit among the plurality of data compression circuits 30.

Optionally, the demultiplexer 60 may be a specially designed demultiplexer, and may support both distributing a single input signal to a plurality of output ends based on a control signal, and distributing a single input signal to one of the plurality of output ends for output based on the control signal.

As shown in FIG. 3, the demultiplexer 60 may include an input end Q1, a control end Q2, and a plurality of output ends Q3. The input end Q1 may be electrically connected to the data obtaining circuit 10 through the bus 62, the plurality of output ends Q3 may be electrically connected in one-to-one correspondence to a plurality of data obtaining circuits 10 through a plurality of buses 64, and the control end Q2 may be electrically connected to the control circuit 20. The second bus between the data obtaining circuit 10 and any data compression circuit 30 may include the bus 62 and the bus 64 corresponding to that data compression circuit 30.

Before controlling the plurality of data compression circuits 30 to compress the sample data in the to-be-compressed data respectively, the control circuit 20 may send a second control signal to the demultiplexer 60 through the bus 66, so that the demultiplexer 60 responds to the second control signal and connects the input end Q1 of the demultiplexer 60 and each output end Q3 of the plurality of output ends Q3. When the input end Q1 of the demultiplexer 60 is connected to each of the plurality of output ends Q3, the second buses (each second bus includes the bus 62 and the corresponding bus 64) between the data obtaining circuit 10 and the plurality of data compression circuits 30 are all conducted. Correspondingly, the sample data may be transmitted to the corresponding data compression circuits 30 through the second buses. Therefore, the plurality of data compression circuits 30 can all receive the sample data, and can compress the sample data respectively to generate the first compressed data respectively corresponding to the plurality of data compression circuits 30.

Before controlling the target data compression circuit to compress the data other than the sample data (that is, the non-sample data) in the to-be-compressed data, the control circuit 20 may send a third control signal to the demultiplexer 60 through the bus 66, so that the demultiplexer 60 responds to the third control signal to maintain the input end Q1 of the demultiplexer 60 connected to the output end Q3 corresponding to the target data compression circuit, and disconnect the input end Q1 of the demultiplexer 60 from the output ends Q3 other than the output end Q3 corresponding to the target data compression circuit. In this way, the second bus between the data obtaining circuit 10 and the target data compression circuit may remain connected, while the second buses between the data obtaining circuit 10 and other data compression circuits may be switched to a disconnected status. Correspondingly, the non-sample data may be transmitted to the target data compression circuit through the second bus corresponding to the target data compression circuit, and would not be transmitted to other data compression circuits.

In the embodiments of this disclosure, by introducing the demultiplexer 60 and controlling the demultiplexer 60 by using the control circuit 20, the sample data may be transmitted to the various data compression circuits 30 for compression through the corresponding second buses, and the non-sample data may be transmitted only to the target data compression circuit for compression through the corresponding second bus. In this way, not only the data compression result of the to-be-compressed data can be generated, but unnecessary data transmission can also be avoided, thereby saving bandwidth resources and power consumption.

In some optional examples, as shown in FIG. 4, the target system may further include:
a data source 70; and
an address generation circuit 80, wherein the address generation circuit 80 is configured to obtain data compression configuration information; determine an original to-be-read address range in the data source 70 that is indicated by the data compression configuration information; and divide the original to-be-read address range into a plurality of target to-be-read address ranges.

That the data obtaining circuit 10 is configured to obtain to-be-compressed data may include:
the data obtaining circuit 10 is configured to obtain a plurality of the corresponding to-be-compressed data from the data source 70 according to the plurality of target to-be-read address ranges.

That the data output circuit 40 is configured to output the second compressed data and the first compressed data corresponding to the target data compression circuit may include:
the data output circuit 40 is configured to, for each of the plurality of the corresponding to-be-compressed data, perform an operation of outputting the first compressed data corresponding to the target data compression circuit and the second compressed data.

Optionally, the data source 70 may be a circuit in the target system that is configured to supply data that needs to be compressed to the data obtaining circuit 10. For example, the data source 70 may be a memory, such as a static random access memory. The data obtaining circuit 10 may be electrically connected to the data source 70.

Optionally, the address generation circuit 80 may be a circuit with a memory address calculation function in the target system. The address generation circuit 80 may also be referred to as an address generation unit (AGU). The data obtaining circuit 10 may be electrically connected to the address generation circuit 80.

In the embodiments of this disclosure, the address generation circuit 80 may obtain data compression configuration information from outside of the target system. For example, the address generation circuit 80 may receive data compression configuration information from a central processing unit, a graphics processing unit (GPU), or a digital signal processor (DSP) outside the target system. The data compression configuration information may be configuration information related to data compression, for example, may be used to indicate the data that needs to be compressed and some compression parameters. The data compression configuration information may include the to-be-read address range of the data source 70, and the address generation circuit 80 may determine the to-be-read address range as the original to-be-read address range in the data source 70 that is indicated by the data compression configuration information. The address generation circuit 80 may divide the original to-be-read address range into a plurality of target to-be-read address ranges. For example, the address generation circuit 80 may divide the original to-be-read address range according to a preset third data amount, so that at most one target to-be-read address range among the plurality of target to-be-read address ranges obtained through division corresponds to a data amount that is different from the third data amount. The data amount corresponding to any target to-be-read address range refers to an amount of data that can be accommodated in a storage space with that target to-be-read address range. The address generation circuit 80 may notify the data obtaining circuit 10 of the plurality of target to-be-read address ranges.

The data obtaining circuit 10 may arrange the plurality of target to-be-read address ranges in sequence. The data obtaining circuit 10 may first initiate a corresponding read request to the data source 70 for a first target to-be-read address range, so as to obtain to-be-compressed data corresponding to the first target to-be-read address range from the data source 70. Subsequently, the data obtaining circuit 10 may initiate a corresponding read request to the data source 70 for a second target to-be-read address range, so as to obtain to-be-compressed data corresponding to the second target to-be-read address range from the data source 70. Subsequently, the data obtaining circuit 10 may further initiate a corresponding read request to the data source 70 for a third target to-be-read address range, so as to obtain to-be-compressed data corresponding to the third target to-be-read address range from the data source 70. The others may be deduced by analogy, until the data obtaining circuit 10 obtains a plurality of to-be-compressed data in one-to-one correspondence to the plurality of target to-be-read address ranges from the data source 70.

After the to-be-compressed data corresponding to any target to-be-read address range is obtained by the data obtaining circuit 10, the target data compression circuit may be determined for that to-be-compressed data by using the manner described above, and the first compressed data corresponding to the target data compression circuit and the second compressed data may be output. This is equivalent to generating and outputting data compression results for the plurality of to-be-compressed data.

In the embodiments of this disclosure, the original to-be-read address range determined based on the data compression configuration information may be divided into a plurality of target to-be-read address ranges, and the plurality of corresponding to-be-compressed data may be obtained according to the plurality of target to-be-read address ranges. Moreover, the plurality of to-be-compressed data may be compressed respectively according to the hardware compression architecture described above. This is equivalent to splitting the data that needs to be compressed (corresponding to the original to-be-read address range) into a plurality of data segments (each of the plurality of to-be-compressed data is a data segment), and the plurality of data segments are compressed respectively. Therefore, each data segment can be compressed by using an appropriate compression algorithm. In this way, even if there are significant differences between data characteristics of different regions in the data that needs to be compressed, good data compression effects can be achieved for different regions, thereby improving an overall data compression effect for the data that needs to be compressed.

In some optional examples, as shown in FIG. 4, the target system may further include:
a data source 70; and
an address generation circuit 80, wherein the address generation circuit 80 is configured to obtain data compression configuration information; determine a target to-be-read address range in the data source 70 based on the data compression configuration information; and divide the target to-be-read address range into a first address range corresponding to a target sample data amount and a second address range other than the first address range.

That the data obtaining circuit 10 is configured to obtain to-be-compressed data includes:
before the control circuit 20 controls the plurality of data compression circuits 30 to compress the sample data in the to-be-compressed data respectively, the data obtaining circuit 10 is configured to obtain the sample data from the data source 70 according to the first address range; and
before the control circuit 20 controls the target data compression circuit to compress the data other than the sample data in the to-be-compressed data, the data obtaining circuit 10 is configured to obtain the data other than the sample data in the to-be-compressed data from the data source 70 according to the second address range.

Optionally, the data source 70 may be a circuit in the target system that is configured to supply data that needs to be compressed to the data obtaining circuit 10. For example, the data source 70 may be a memory. The data obtaining circuit 10 may be electrically connected to the data source 70.

Optionally, the address generation circuit 80 may be a circuit with a memory address calculation function in the target system. The data obtaining circuit 10 may be electrically connected to the address generation circuit 80.

In the embodiments of this disclosure, the address generation circuit 80 may obtain data compression configuration information from outside of the target system. The data compression configuration information may include the to-be-read address range of the data source 70, and the address generation circuit 80 may determine the to-be-read address range as the original to-be-read address range in the data source 70 that is indicated by the data compression configuration information. The address generation circuit 80 may further determine the target to-be-read address range based on the original to-be-read address range. Herein, the address generation circuit 80 may determine the original to-be-read address range as the target to-be-read address range. Alternatively, the address generation circuit 80 may divide the original to-be-read address range into a plurality of target to-be-read address ranges. For ease of understanding, description is made below by using an example in which the address generation circuit 80 determines the original to-be-read address range as the target to-be-read address range.

The address generation circuit 80 may divide the target to-be-read address range to obtain the first address range corresponding to the target sample data amount and the second address range other than the first address range. The target sample data amount may be a preset data amount of the sample data, or may be a data amount of the sample data that is specified through the data compression configuration information. The correspondence between the first address range and the target sample data amount may be understood as: by reading the first address range of the data source 70, a data amount of obtained read data is the target sample data amount. The address generation circuit 80 may notify the data obtaining circuit 10 of the first address range and the second address range.

Before the control circuit 20 controls the plurality of data compression circuits 30 to compress the sample data in the to-be-compressed data respectively, the data obtaining circuit 10 may initiate a corresponding read request to the data source 70 according to the first address range, to obtain the corresponding read data from the data source 70. The data obtaining circuit 10 may determine the read data as the sample data. Through the demultiplexer 60 described above, the data obtaining circuit 10 may transmit the sample data to the plurality of data compression circuits 30 for compression. Thus, the first compressed data respectively corresponding to the plurality of data compression circuits 30 may be generated.

Before the control circuit 20 controls the target data compression circuit to compress the data other than the sample data in the to-be-compressed data, the data obtaining circuit 10 may initiate a corresponding read request to the data source 70 according to the second address range, to obtain the corresponding read data from the data source 70. The data obtaining circuit 10 may determine the read data as the non-sample data. Through the demultiplexer 60 described above, the data obtaining circuit 10 may transmit the non-sample data to the target data compression circuit for compression. Thus, the second compressed data may be generated.

In the embodiments of this disclosure, the address generation circuit 80 may efficiently and reliably determine the target to-be-read address range based on the data compression configuration information; and the target to-be-read address range may be efficiently and reliably divided into the first address range and the second address range based on the target sample data amount. The first address range may provide effective reference for obtaining the sample data, while the second address range may provide effective reference for obtaining the non-sample data. On this basis, the data obtaining circuit 10 can efficiently and reliably obtain all to-be-compressed data from the data source 70.

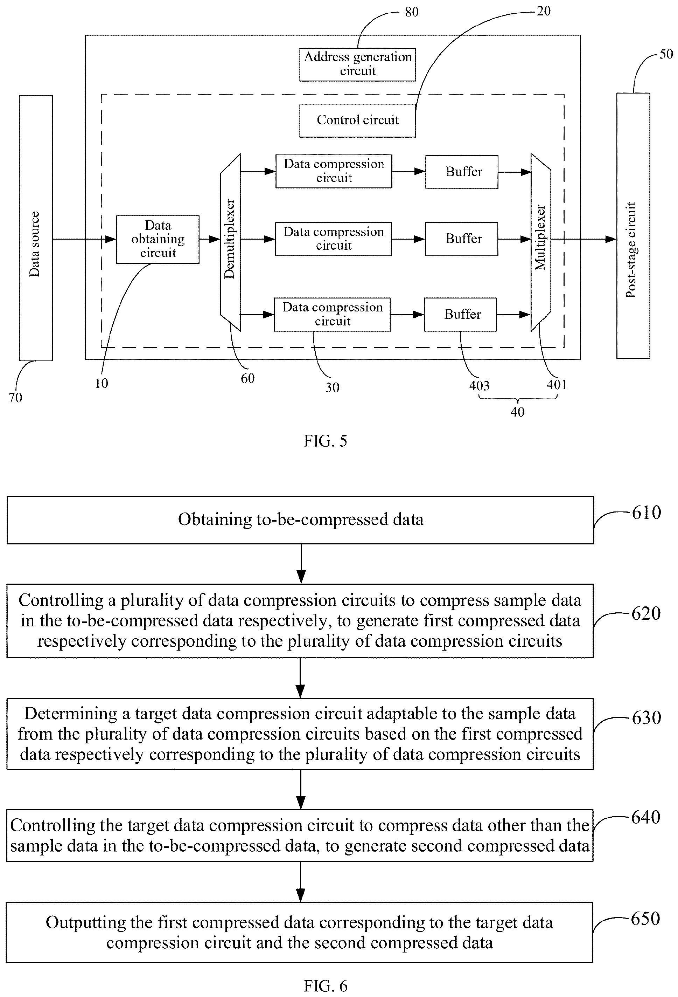

Referring to FIG. 5, the address generation circuit 80 may obtain the data compression configuration information, determine the target to-be-read address range based on the data compression configuration information, and divide the target to-be-read address range to obtain the first address range and the second address range.

The data obtaining circuit 10 may obtain the sample data from the data source 70 according to the first address range, and transmit the sample data to the demultiplexer 60. In this case, the control circuit 20 may control the demultiplexer 60 to output the sample data from the demultiplexer 60 to the plurality of data compression circuits 30. The plurality of data compression circuits 30 may compress the sample data respectively to generate the first compressed data respectively corresponding to the plurality of data compression circuits 30. The first compressed data respectively corresponding to the plurality of data compression circuits 30 may be stored in the corresponding buffers 403, respectively.

The control circuit 20 may determine the compression ratios corresponding to the plurality of data compression circuits 30 based on the first compressed data respectively corresponding to the plurality of data compression circuits 30. On this basis, the target data compression circuit adaptable to the sample data may be determined from the plurality of data compression circuits 30. The control circuit 20 may also control the multiplexer 401 to output the first compressed data buffered in the buffer 403 corresponding to the target data compression circuit to the post-stage circuit 50 through the multiplexer 401. Optionally, the first compressed data buffered in the buffers 403 other than the buffer 403 corresponding to the target data compression circuit may be deleted.

The data obtaining circuit 10 may obtain the non-sample data from the data source 70 according to the second address range, and transmit the non-sample data to the demultiplexer 60. In this case, the control circuit 20 may control the demultiplexer 60 to output the non-sample data from the demultiplexer 60 to the target data compression circuit only. The target data compression circuit may compress the non-sample data to obtain the second compressed data, which may be stored in the buffer 403 corresponding to the target data compression circuit. The control circuit 20 may control the multiplexer 401 to output the second compressed data buffered in the buffer 403 corresponding to the target data compression circuit to the post-stage circuit 50 through the multiplexer 401.

Optionally, if the control circuit 20 determines the plurality of target to-be-read address ranges based on the data compression configuration information, relevant operations described in the embodiments for FIG. 5 may be performed for each target to-be-read address range to implement data compression for the to-be-compressed data corresponding to the target to-be-read address range.

Optionally, the data source 70 in FIG. 5 may be considered as a first component of the target system, the post-stage circuit 50 in FIG. 5 may be considered as a second component of the target system, and a part, other than the address generation circuit 80, in FIG. 5 that is located between the data source 70 and the post-stage circuit 50 may be considered as a third component of the target system. In an example, the first component may be an on-chip SRAM, the second component may be an off-chip DDR, and the third component may be a STORE module (that is, a storage module). In another example, the first component may be a L1-level SRAM (that is, an on-chip level-1 static random access memory), the second component may be an on-chip L2-level SRAM (that is, an on-chip level-2 static random access memory), and the third component may be a dedicated compression module.

In view of the above, the embodiments this disclosure provide a dynamically adaptive hardware compression architecture that can integrate a plurality of compression algorithms (in one-to-one correspondence to the plurality of data compression circuits 30) in the target system, and adaptively select the compression algorithms based on data characteristics of the to-be-compressed data, which helps achieve an optimal data compression effect (such as an optimal compression ratio). Moreover, the hardware compression architecture is flexible and efficient, and can be applied to various scenarios.

### Exemplary method

FIG. 6 is a schematic flowchart of a data compression method according to some exemplary embodiments of this disclosure. The method shown in FIG. 6 may include:
Step 610: Obtaining to-be-compressed data;
Step 620: Controlling a plurality of data compression circuits to compress sample data in the to-be-compressed data respectively, to generate first compressed data respectively corresponding to the plurality of data compression circuits;
Step 630: Determining a target data compression circuit adaptable to the sample data from the plurality of data compression circuits based on the first compressed data respectively corresponding to the plurality of data compression circuits;
Step 640: Controlling the target data compression circuit to compress data other than the sample data in the to-be-compressed data, to generate second compressed data; and
Step 650: Outputting the first compressed data corresponding to the target data compression circuit and the second compressed data.

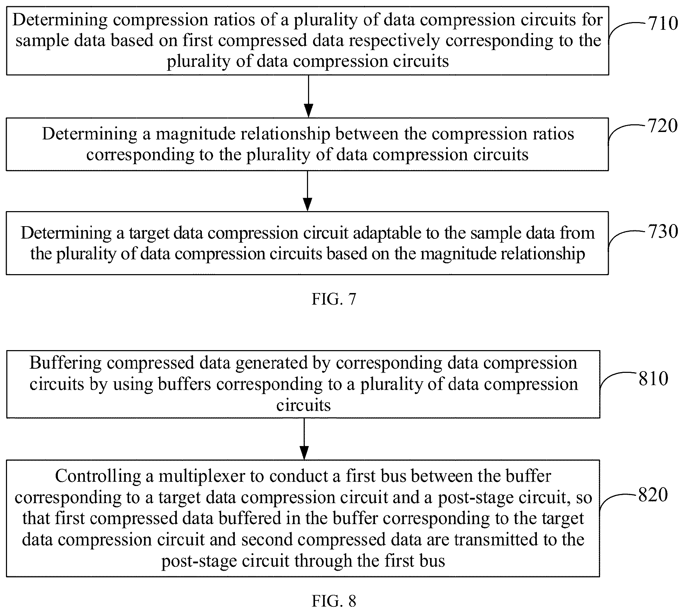

In some optional examples, as shown in FIG. 7, step 630 may include:
Step 710: Determining respective compression ratios of the plurality of data compression circuits for the sample data based on the first compressed data respectively corresponding to the plurality of data compression circuits;
Step 720: Determining a magnitude relationship between the compression ratios corresponding to the plurality of data compression circuits; and
Step 730: Determining the target data compression circuit adaptable to the sample data from the plurality of data compression circuits based on the magnitude relationship.

In some optional examples, as shown in FIG. 8, step 650 may include:
Step 810: Buffering compressed data generated by the corresponding data compression circuits by using the buffers respectively corresponding to the plurality of data compression circuits; and
Step 820: Controlling the multiplexer to conduct a first bus between the buffer corresponding to the target data compression circuit and the post-stage circuit, so that the first compressed data buffered in the buffer corresponding to the target data compression circuit and the second compressed data are transmitted to the post-stage circuit through the first bus.

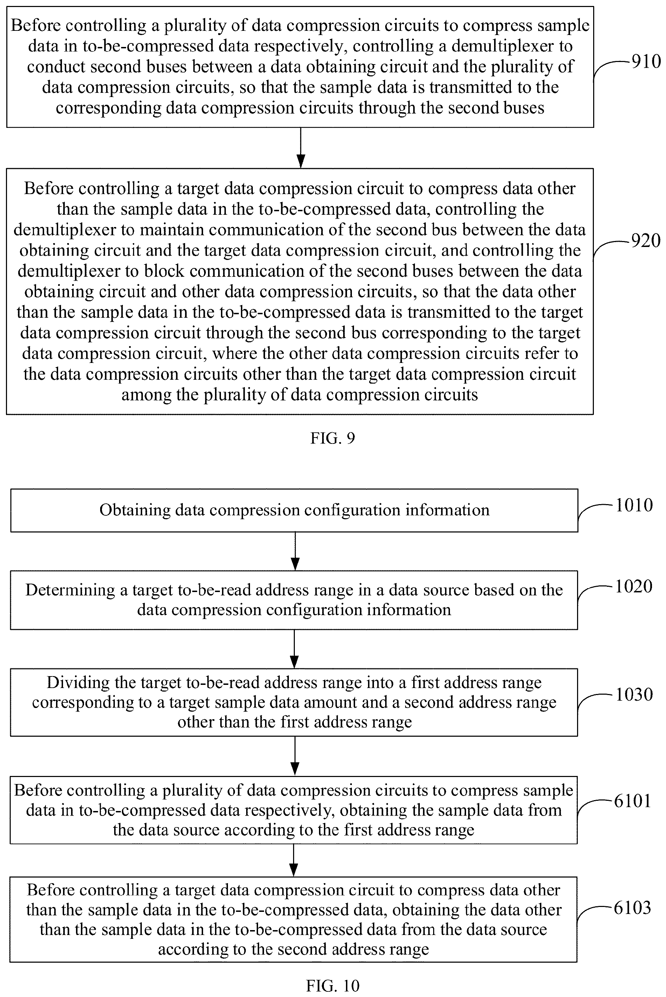

In some optional examples, as shown in FIG. 9, the method provided in the embodiments of this disclosure may further include:
Step 910: Before controlling the plurality of data compression circuits to compress the sample data in the to-be-compressed data respectively, controlling the demultiplexer to conduct second buses between the data obtaining circuit and the plurality of data compression circuits, so that the sample data is transmitted to the corresponding data compression circuits through the second buses; and
Step 920: Before controlling the target data compression circuit to compress the data other than the sample data in the to-be-compressed data, controlling the demultiplexer to maintain communication of the second bus between the data obtaining circuit and the target data compression circuit, and controlling the demultiplexer to block communication of the second buses between the data obtaining circuit and other data compression circuits, so that the data other than the sample data in the to-be-compressed data is transmitted to the target data compression circuit through the second bus corresponding to the target data compression circuit, wherein the other data compression circuits refer to the data compression circuits other than the target data compression circuit among the plurality of data compression circuits.

In some optional examples, as shown in FIG. 10, the method provided in the embodiments of this disclosure may further include:
Step 1010: Obtaining data compression configuration information;
Step 1020: Determining a target to-be-read address range in a data source based on the data compression configuration information; and
Step 1030: Dividing the target to-be-read address range into a first address range corresponding to a target sample data amount and a second address range other than the first address range.
Step 610 may include:
   Step 6101: Before controlling the plurality of data compression circuits to compress the sample data in the to-be-compressed data respectively, obtaining the sample data from the data source according to the first address range; and
   Step 6103: Before controlling the target data compression circuit to compress the data other than the sample data in the to-be-compressed data, obtaining the data other than the sample data in the to-be-compressed data from the data source according to the second address range.

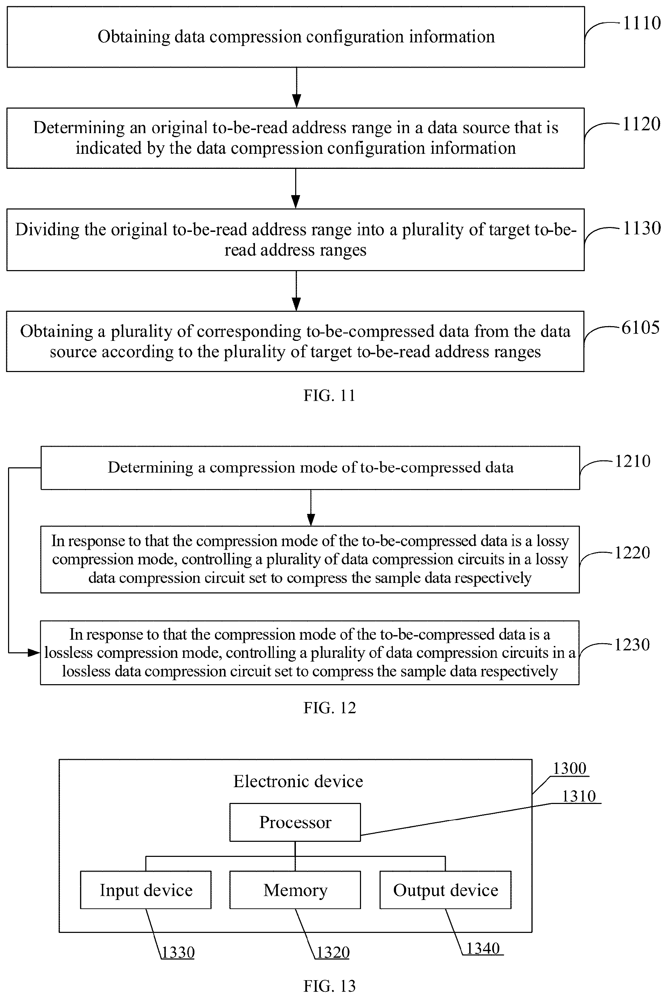

In some optional examples, as shown in FIG. 11, the method provided in the embodiments of this disclosure may further include:
Step 1110: Obtaining data compression configuration information;
Step 1120: Determining an original to-be-read address range in the data source that is indicated by the data compression configuration information; and
Step 1130: Dividing the original to-be-read address range into a plurality of target to-be-read address ranges.
Step 610 may include:
   Step 6105: Obtaining a plurality of the corresponding to-be-compressed data from the data source according to the plurality of target to-be-read address ranges.
   Step 650 may include:
      for each of the plurality of the corresponding to-be-compressed data, performing an operation of outputting the first compressed data corresponding to the target data compression circuit and the second compressed data.

In some optional examples, as shown in FIG. 12, step 620 may include:
Step 1210: Determining a compression mode of the to-be-compressed data;
Step 1220: In response to that the compression mode of the to-be-compressed data is a lossy compression mode, controlling a plurality of data compression circuits in a lossy data compression circuit set to compress the sample data respectively; and
Step 1230: In response to that the compression mode of the to-be-compressed data is a lossless compression mode, controlling a plurality of data compression circuits in a lossless data compression circuit set to compress the sample data respectively.

In some optional examples, step 1220 of controlling a plurality of data compression circuits in a lossy data compression circuit set to compress the sample data respectively may include:
determining a shared information loss rate of the plurality of data compression circuits in the lossy data compression circuit set; and
controlling the plurality of data compression circuits in the lossy data compression circuit set to compress the sample data respectively according to the shared information loss rate.

In the method in this disclosure, various optional embodiments, optional implementations, and optional examples in the section of exemplary system described above may be flexibly selected and combined according to requirements, so as to implement corresponding functions and effects. These are not enumerated in this disclosure.

For beneficial technical effects corresponding to the exemplary embodiments of this method, reference may be made to the corresponding beneficial technical effects in the section of exemplary system described above, and details are not described herein again.

### Exemplary electronic device

FIG. 13 is a block diagram of an electronic device according to an embodiment of this disclosure. An electronic device 1300 includes one or more processors 1310 and a memory 1320.

The processor 1310 may be a central processing unit (CPU) or another form of processing unit having a data processing capability and/or an instruction execution capability, and may control other components in the electronic device 1300 to implement desired functions.

The memory 1320 may include one or more computer program products, which may include various forms of computer readable storage media, such as a volatile memory and/or a non-volatile memory. The volatile memory may include, for example, a random access memory (RAM) and/or a cache. The nonvolatile memory may include, for example, a read-only memory (ROM), a hard disk, and a flash memory. One or more computer program instructions may be stored on the computer readable storage medium. The processor 1310 may execute the one or more program instructions to implement the method according to various embodiments of this disclosure that are described above and/or other desired functions.

In an example, the electronic device 1300 may further include an input device 1330 and an output device 1340. These components are connected to each other through a bus system and/or another form of connection mechanism (not shown).

The input device 1330 may further include, for example, a keyboard and a mouse.

The output device 1340 may output various information to the outside, and may include, for example, a display, a speaker, a printer, a communication network, and a remote output device connected to the communication network.

Certainly, for simplicity, FIG. 13 shows only some of components in the electronic device 1300 that are related to this disclosure, and components such as a bus and an input/output interface are omitted. In addition, according to specific application situations, the electronic device 1300 may further include any other appropriate components.

### Exemplary computer program product and computer readable storage medium

In addition to the foregoing method and device, embodiments of this disclosure may also relate to a computer program product, which includes computer program instructions. When the instructions are run by a processor, the processor is enabled to perform the steps, of the method according to the embodiments of this disclosure, that are described in the "Exemplary method" section of this specification.

The computer program product may be program code, written with one or any combination of a plurality of programming languages, that is configured to perform the operations in the embodiments of this disclosure. The programming languages include an object-oriented programming language such as Java or C++, and further include a conventional procedural programming language such as a "C" language or a similar programming language. The program code may be entirely or partially executed on a user computing device, executed as an independent software package, partially executed on the user computing device and partially executed on a remote computing device, or entirely executed on the remote computing device or a server.

In addition, the embodiments of this disclosure may further relate to a computer readable storage medium, which stores computer program instructions. When the computer program instructions are run by the processor, the processor is enabled to perform the steps, of the method according to the embodiments of this disclosure, that are described in the "Exemplary method" section of this specification.

The computer readable storage medium may be one readable medium or any combination of a plurality of readable media. The readable medium may be a readable signal medium or a readable storage medium. The readable storage medium may include, for example but is not limited to electricity, magnetism, light, electromagnetism, infrared ray, or a semiconductor system, an apparatus, or a device, or any combination of the above. More specific examples (a non-exhaustive list) of the readable storage medium include: an electrical connection with one or more conducting wires, a portable disk, a hard disk, a random access memory (RAM), a read-only memory (ROM), an erasable programmable read-only memory (EPROM or a flash memory), an optical fiber, a portable compact disk read-only memory (CD-ROM), an optical storage device, a magnetic storage device, or any suitable combination of the above.

Basic principles of this disclosure are described above in combination with specific embodiments. However, advantages, superiorities, and effects mentioned in this disclosure are merely examples but are not for limitation, and it cannot be considered that these advantages, superiorities, and effects are necessary for each embodiment of this disclosure. Specific details described above are merely for examples and for ease of understanding, rather than limitations. The details described above do not limit that this disclosure must be implemented by using the foregoing specific details.

A person skilled in the art may make various modifications and variations to this disclosure without departing from the spirit and the scope of this application. In this way, if these modifications and variations of this application fall within the scope of the claims and equivalent technologies of the claims of this disclosure, this disclosure also intends to include these modifications and variations.

## Claims

1. A system for implementing data compression, **characterized in that** the system comprises:
a data obtaining circuit (10), wherein the data obtaining circuit (10) is configured to obtain to-be-compressed data;
a control circuit (20) and a plurality of data compression circuits (30), wherein the control circuit (20) is configured to control the plurality of data compression circuits (30) to compress sample data in the to-be-compressed data respectively, to generate first compressed data respectively corresponding to the plurality of data compression circuits (30); determine a target data compression circuit (30) adaptable to the sample data from the plurality of data compression circuits (30) based on the first compressed data respectively corresponding to the plurality of data compression circuits (30); and control the target data compression circuit (30) to compress data other than the sample data in the to-be-compressed data, to generate second compressed data; and
a data output circuit (40), wherein the data output circuit (40) is configured to output the first compressed data corresponding to the target data compression circuit (30) and the second compressed data.

2. The system according to claim 1, wherein that the control circuit (20) is configured to determine a target data compression circuit (30) adaptable to the sample data from the plurality of data compression circuits (30) based on the first compressed data respectively corresponding to the plurality of data compression circuits (30) comprises:
the control circuit (20) is configured to determine respective compression ratios of the plurality of data compression circuits (30) for the sample data based on the first compressed data respectively corresponding to the plurality of data compression circuits (30); determine a magnitude relationship between the compression ratios corresponding to the plurality of data compression circuits (30); and determine the target data compression circuit (30) adaptable to the sample data from the plurality of data compression circuits (30) based on the magnitude relationship.

3. The system according to claim 1 or 2, wherein the data output circuit (40) comprises a multiplexer (401) and buffers (403) respectively corresponding to the plurality of data compression circuits (30); the system further comprises a post-stage circuit (50); and
that the data output circuit (40) is configured to output the first compressed data corresponding to the target data compression circuit (30) and the second compressed data comprises:
the buffers (403) respectively corresponding to the plurality of data compression circuits (30) are configured to buffer (403) compressed data generated by the corresponding data compression circuits (30); and
the control circuit (20) is configured to control the multiplexer (401) to conduct a first bus between the buffer (403) corresponding to the target data compression circuit (30) and the post-stage circuit (50), so that the first compressed data buffered in the buffer (403) corresponding to the target data compression circuit (30) and the second compressed data are transmitted to the post-stage circuit (50) through the first bus.

4. The system according to any one of the claims 1 to 3, wherein the system further comprises a demultiplexer (60);
before being configured to control the plurality of data compression circuits (30) to compress the sample data in the to-be-compressed data respectively, the control circuit (20) is configured to control the demultiplexer (60) to conduct second buses between the data obtaining circuit (10) and the plurality of data compression circuits (30), so that the sample data is transmitted to the corresponding data compression circuits (30) through the second buses; and
before being configured to control the target data compression circuit (30) to compress the data other than the sample data in the to-be-compressed data, the control circuit (20) is configured to control the demultiplexer (60) to maintain communication of the second bus between the data obtaining circuit (10) and the target data compression circuit (30), and control the demultiplexer (60) to block communication of the second buses between the data obtaining circuit (10) and other data compression circuits (30), so that the data other than the sample data in the to-be-compressed data is transmitted to the target data compression circuit (30) through the second bus corresponding to the target data compression circuit (30), wherein the other data compression circuits (30) refer to the data compression circuits (30) other than the target data compression circuit (30) among the plurality of data compression circuits (30).

5. The system according to any one of the claims 1 to 4, wherein the system further comprises:
a data source (70); and
an address generation circuit (80), wherein the address generation circuit (80) is configured to obtain data compression configuration information; determine a target to-be-read address range in the data source (70) based on the data compression configuration information; and divide the target to-be-read address range into a first address range corresponding to a target sample data amount and a second address range other than the first address range; and
that the data obtaining circuit (10) is configured to obtain to-be-compressed data comprises:
before the control circuit (20) controls the plurality of data compression circuits (30) to compress the sample data in the to-be-compressed data respectively, the data obtaining circuit (10) is configured to obtain the sample data from the data source (70) according to the first address range; and
before the control circuit (20) controls the target data compression circuit (30) to compress the data other than the sample data in the to-be-compressed data, the data obtaining circuit (10) is configured to obtain the data other than the sample data in the to-be-compressed data from the data source (70) according to the second address range.

6. The system according to any one of the claims 1 to 4, wherein the system further comprises:
a data source (70); and
an address generation circuit (80), wherein the address generation circuit (80) is configured to obtain data compression configuration information; determine an original to-be-read address range in the data source (70) that is indicated by the data compression configuration information; and divide the original to-be-read address range into a plurality of target to-be-read address ranges;
that the data obtaining circuit (10) is configured to obtain to-be-compressed data comprises:
the data obtaining circuit (10) is configured to obtain a plurality of the corresponding to-be-compressed data from the data source (70) according to the plurality of target to-be-read address ranges; and
that the data output circuit (40) is configured to output the first compressed data corresponding to the target data compression circuit (30) and the second compressed data comprises:
the data output circuit (40) is configured to, for each of the plurality of the corresponding to-be-compressed data, perform an operation of outputting the first compressed data corresponding to the target data compression circuit (30) and the second compressed data.

7. The system according to any one of the claims 1 to 6, wherein the system comprises:
a lossy data compression circuit set and a lossless data compression circuit set; and
that the control circuit (20) is configured to control the plurality of data compression circuits (30) to compress sample data in the to-be-compressed data respectively comprises:
the control circuit (20) is configured to determine a compression mode of the to-be-compressed data; in response to that the compression mode of the to-be-compressed data is a lossy compression mode, control a plurality of data compression circuits (30) in the lossy data compression circuit set to compress the sample data respectively; and in response to that the compression mode of the to-be-compressed data is a lossless compression mode, control a plurality of data compression circuits (30) in the lossless data compression circuit set to compress the sample data respectively.

8. The system according to claim 7, wherein that the control circuit (20) is configured to control a plurality of data compression circuits (30) in the lossy data compression circuit set to compress the sample data respectively comprises:
the control circuit (20) is configured to determine a shared information loss rate of the plurality of data compression circuits (30) in the lossy data compression circuit set; and control the plurality of data compression circuits (30) in the lossy data compression circuit set to compress the sample data respectively according to the shared information loss rate.

9. A data compression method, **characterized in that** the method comprises:
Obtaining (610) to-be-compressed data;
controlling (620) a plurality of data compression circuits to compress sample data in the to-be-compressed data respectively, to generate first compressed data respectively corresponding to the plurality of data compression circuits;
determining (630) a target data compression circuit adaptable to the sample data from the plurality of data compression circuits based on the first compressed data respectively corresponding to the plurality of data compression circuits;
controlling (640) the target data compression circuit to compress data other than the sample data in the to-be-compressed data, to generate second compressed data; and
outputting (650) the first compressed data corresponding to the target data compression circuit and the second compressed data.

10. The method according to claim 9, wherein the determining (630) a target data compression circuit adaptable to the sample data from the plurality of data compression circuits based on the first compressed data respectively corresponding to the plurality of data compression circuits comprises:
determining (710) respective compression ratios of the plurality of data compression circuits for the sample data based on the first compressed data respectively corresponding to the plurality of data compression circuits;
determining (720) a magnitude relationship between the compression ratios corresponding to the plurality of data compression circuits; and
determining (730) the target data compression circuit adaptable to the sample data from the plurality of data compression circuits based on the magnitude relationship.

11. The method according to claim 9 or 10, wherein the outputting (650) the first compressed data corresponding to the target data compression circuit and the second compressed data comprises:
buffering (810) compressed data generated by the corresponding data compression circuits by using the buffers respectively corresponding to the plurality of data compression circuits; and
controlling (820) the multiplexer to conduct a first bus between the buffer corresponding to the target data compression circuit and the post-stage circuit, so that the first compressed data buffered in the buffer corresponding to the target data compression circuit and the second compressed data are transmitted to the post-stage circuit through the first bus.

12. The method according to any one of the claims 9 to 11, further comprising:
before controlling the plurality of data compression circuits to compress the sample data in the to-be-compressed data respectively, controlling (910) the demultiplexer to conduct second buses between the data obtaining circuit and the plurality of data compression circuits, so that the sample data is transmitted to the corresponding data compression circuits through the second buses; and
before controlling the target data compression circuit to compress the data other than the sample data in the to-be-compressed data, controlling (920) the demultiplexer to maintain communication of the second bus between the data obtaining circuit and the target data compression circuit, and controlling the demultiplexer to block communication of the second buses between the data obtaining circuit and other data compression circuits, so that the data other than the sample data in the to-be-compressed data is transmitted to the target data compression circuit through the second bus corresponding to the target data compression circuit, wherein the other data compression circuits refer to the data compression circuits other than the target data compression circuit among the plurality of data compression circuits.

13. The method according to any one of the claims 9 to 12, further comprising:
obtaining (1010) data compression configuration information;
determining (1020) a target to-be-read address range in a data source based on the data compression configuration information; and
dividing (1030) the target to-be-read address range into a first address range corresponding to a target sample data amount and a second address range other than the first address range.

14. A computer readable storage medium, on which a computer program is stored, wherein the computer program, when executed by a processor, causes the processor to implement the data compression method according to any one of the claims 9 to 13.

15. An electronic device, **characterized in that** the electronic device comprises:
a processor (1310); and
a memory (1320), configured to store processor-executable instructions, wherein
the processor (1310) is configured to read the executable instructions from the memory (1320), and execute the instructions to implement the data compression method according to any one of the claims 9 to 13.
